# EUROPEAN PATENT APPLICATION

(11) **EP 3 514 839 A1**
(43) Date of publication of application: **24.07.2019**
(21) Application number: 17850081.5
(22) Date of filing: 06.07.2017
(51) Int. Cl.: H01L 31/042

(54) **SOLAR CELL ASSEMBLY AND AEROSTAT**

(30) Priority: 14.09.2016 CN 201610824030
(71) Applicant: Haikou Institute Of Future Technology, Haikou, Hainan 570100 (CN)
(72) Inventor: LIU, RuoPeng, Shenzhen Guangdong 518057 (CN); LUAN, Lin, Shenzhen Guangdong 518057 (CN); LIAO, WenDi, Shenzhen Guangdong 518057 (CN); ZHENG, Xiang, Shenzhen Guangdong 518057 (CN); BA, ZhiKun, Shenzhen Guangdong 518057 (CN)
(74) Representative: Goddar, Heinz J.
(86) International application number: PCT/CN2017/092012
(87) International publication number: WO 2018/049878

(57) **Abstract**

A solar cell assembly and an aerostat are disclosed. The solar cell assembly includes: a flexible base plate; and a plurality of rigid solar cells that are connected in series by using a conducting wire and that are disposed on a surface of the flexible base plate. According to the solar cell assembly provided in the present invention, the rigid solar cells are disposed on the flexible base plate. Therefore, the entire solar cell assembly can bend freely under specific pressure. The rigid solar cells do not bend as the entire device bends, thereby protecting the rigid solar cells from damage and implementing application of the rigid solar cells on a non-planar structure. A structure is simple, optical-to-electrical conversion efficiency is high, flexibility is achieved, and lamination is strong.

## Description

### TECHNICAL FIELD

The present invention relates to the field of cells, and more specifically, to a solar cell assembly and an aerostat having the solar cell assembly.

### BACKGROUND

A solar cell panel needs to be installed on an aerostat such as a near space aerostat to supply power. Generally, there are two types of solar cell panels: a rigid monocrystalline silicon solar panel and a flexible solar cell.

The foregoing two types of solar cells have the following problems:
1. If the rigid monocrystalline silicon solar panel commonly used on the ground is used, the panel cannot be attached to a spheroid capsule shell of an aircraft due to rigidity of a device, and can be only hung at the bottom of a pod. The panel has a quite small light receiving area and a heavy weight, and is insufficient to support electric energy use for an aircraft energy system.
2. The flexible solar cell is attached to a capsule shell. Because energy conversion efficiency of the flexible solar cell is excessively low, a quite large area of flexible solar cells are required to satisfy a power supply requirement, and consequently, an aircraft is overweight.

### SUMMARY

In view of the foregoing problems, an objective of the present invention is to provide a solar cell assembly that has a simple structure, high optical-to-electrical conversion efficiency, flexibility, and strong lamination.

To achieve the objective, the following technical solution is used in the present invention:
a solar cell assembly, including:
a flexible base plate; and
a plurality of rigid solar cells that are connected in series by conducting wire and that are disposed on a surface of the flexible base plate.

Preferably, the plurality of rigid solar cells are arranged on the flexible base plate in a form of an array.

Preferably, the solar cell assembly further includes a plurality of protective housings, where the protective housings are disposed on the flexible base plate, and the plurality of rigid solar cells are respectively disposed in the plurality of protective housings.

Preferably, a plurality of mounting slots are disposed on the flexible base plate, and the plurality of protective housings are respectively disposed in the mounting slots; or the protective housings are bonded to a surface of the flexible base plate; or the plurality of protective housings are fastened to a surface of the flexible base plate by using fasteners.

Preferably, the protective housings are made from a rigid material.

Preferably, the material of the plurality of protective housings is a rigid thermal conductive silicone, a low-temperature resistant epoxy resin, or a titanium alloy.

Preferably, the protective housings, the flexible base plate, and the rigid solar cells form a plane on a lighting receiving surface of the rigid solar cells.

Preferably, the solar cell assembly further includes a protective film, where the protective film covers the plurality of rigid solar cells.

Preferably, a plurality of grooves are disposed on a surface, back to the rigid solar cells, of the flexible base plate.

Preferably, the plurality of grooves are respectively disposed in corresponding locations between adjacent solar cells.

The present invention further provides an aerostat, which uses the foregoing solar cell assembly, to achieve high optical-to-electrical conversion efficiency.

To achieve the objective, the following technical solution is used in the present invention:
an aerostat, including a body and the foregoing solar cell assembly, where a flexible base plate of the solar cell assembly is attached to an outer surface of a capsule shell of the body.

Preferably, the flexible base plate of the solar cell assembly is bonded to the outer surface of the capsule shell of the body by using a flexible bonding agent.

According to the solar cell assembly provided in the present invention, the rigid solar cells are disposed on the flexible base plate. Therefore, the entire solar cell assembly can bend freely under specific pressure. The rigid solar cells do not bend as the entire device bends, thereby protecting the rigid solar cells from damage and implementing application of the rigid solar cells on a non-planar structure. A structure is simple, optical-to-electrical conversion efficiency is high, flexibility is achieved, and lamination is strong.

The foregoing solar cell assembly is applied to the aerostat provided in the present invention. The solar cell assembly is attached to the outer surface of the capsule shell of the aerostat by using the flexible base plate of the solar cell assembly. The structure is simple, and the optical-to-electrical conversion efficiency is high.

### BRIEF DESCRIPTION OF DRAWINGS

The following descriptions of the embodiments of the present invention with reference to the accompanying drawings make the foregoing and other objectives, features, and advantages of the present invention clearer. In the drawings:
FIG. 1 is a partial cutaway diagram of a solar cell assembly according to an embodiment of the present invention;
FIG. 2 is a top view of a solar cell assembly according to an embodiment of the present invention;
FIG. 3 is a partial cutaway diagram of a solar cell assembly according to another embodiment of the present invention;
FIG. 4 is a bottom view of a solar cell assembly according to another embodiment of the present invention; and
FIG. 5 is a schematic structural diagram of an aerostat on which a solar cell assembly is disposed according to the present invention.

In the drawings: 1. flexible base plate; 2. rigid solar cell; 3. connecting wire; 4. protective housing; 5. protective film; 6. groove; 7. capsule shell; 8. flexible bonding agent.

### DESCRIPTION OF EMBODIMENTS

The following describes the present invention based on embodiments, but the present invention is not limited to these embodiments. The following detailed descriptions of the present invention illustrate some particular details. A person skilled in the art can fully understand the present invention without the descriptions of these details. To avoid misunderstanding of the essence of the present invention, well-known methods, processes, procedures, and components are not described in detail.

It should be understood that, when a structure is described and when a layer or an area is referred to be "on the top of' or "above" another layer or another area, it may mean that the layer or the area is directly on the another layer or the another area, or there is still another layer or still another area between the layer or the area and the another layer or the another area. In addition, if the structure is turned over, the layer or the area is "at the bottom of' or "under" the another layer or the another area. To describe a case in which the layer or the area is directly on the another layer or the another area, an expression that "A is directly on B" or "A is on B and is adjacent to B" is used in this specification.

The present invention provides a solar cell assembly, including:
a flexible base plate; and
a plurality of rigid solar cells that are connected in series by conducting wire and that are disposed on a surface of the flexible base plate.

According to the solar cell assembly provided in the present invention, the rigid solar cells are disposed on the flexible base plate. Therefore, the entire solar cell assembly can bend freely under specific pressure. The rigid solar cells do not bend as the entire device bends, thereby protecting the rigid solar cells from damage and implementing application of the rigid solar cells on a non-planar structure. A structure is simple, optical-to-electrical conversion efficiency is high, flexibility is achieved, and lamination is strong.

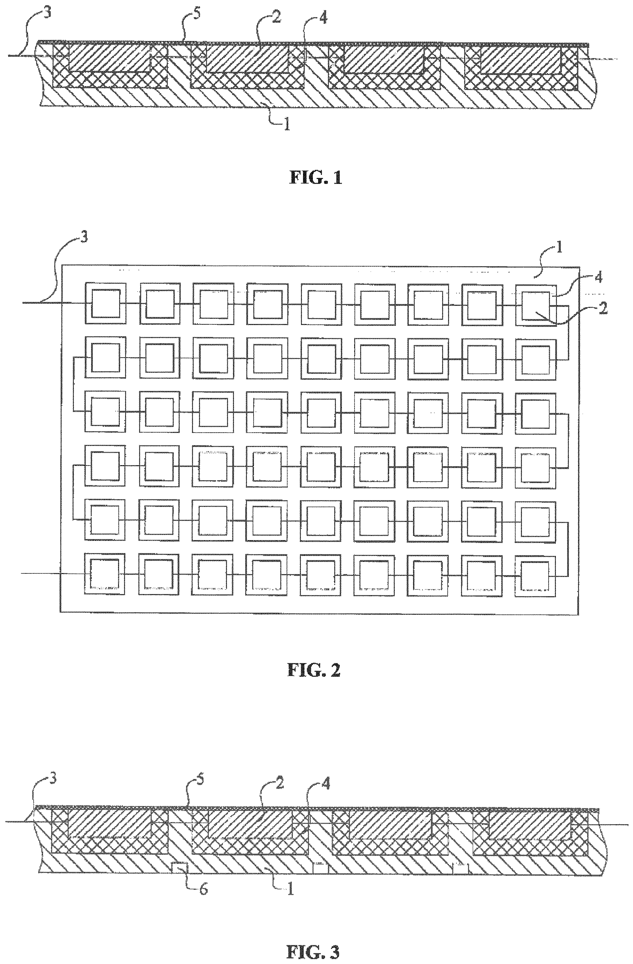

The following describes embodiments of a solar cell assembly of the present invention in detail with reference to FIG. 1 to FIG. 4.

As shown in the figure, the solar cell assembly includes a flexible base plate 1 and a plurality of rigid solar cells 2 disposed on the flexible base plate 1. In this embodiment, the flexible base plate 1 is an one-body structure, that is, the plurality of rigid solar cells 2 are disposed on an independent flexible base plate 1. Because the flexible base plate 1 is used, the solar cell assembly can be mounted on a non-planar structure depending on flexibility of the flexible base plate. A specific material of the flexible base plate 1 is not limited. Preferably, a high-strength high-flexibility polyvinyl chloride material is used. The rigid solar cell 2 is conceptually different from a flexible solar cell. A specific type is not limited, provided that the rigid solar cell can achieve sufficient optical-to-electrical conversion efficiency, for example, a monocrystalline silicon solar cell or a polycrystalline silicon solar cell. A size of the plurality of rigid solar cells 2 may be changed based on an actual situation. For example, the size of the rigid solar cells 2 is adjusted based on a curvature change on an entire surface of a pre-laid aerostat, to better implement bonding between a part of the flexible base plate 1 under the rigid solar cells 2 and a capsule of the aerostat. In addition, it is ensured that conversion efficiency of the solar cells 2 is not affected due to an excessively large quantity of rigid solar cells 2 in a unit area.

Disposal locations of the rigid solar cells 2 are not limited. To achieve higher optical-to-electrical conversion efficiency, the plurality of rigid solar cells 2 are disposed on the flexible base plate 1 in a form of an array, to form a solar cell array. Preferably, the solar cell array includes a plurality of rows and a plurality of columns of rigid solar cells 2. For example, as shown in FIG. 2, the solar cell array includes six rows and nine columns of rigid solar cells 2. The rigid solar cells 2 are sequentially connected by connecting wire 3. A connection sequence of the connecting wire 3 is not limited, provided that all the rigid solar cells 2 are connected. For example, as shown in FIG. 2, the connecting wire 3 sequentially connects the rigid solar cells 2 through snake-like cabling, namely, zigzag cabling.

In a preferred embodiment, to prevent mutual interference between the rigid solar cells 2, a specific gap is disposed between adjacent rigid solar cells 2.

In a further embodiment, the solar cell assembly further includes a plurality of protective housings 4 corresponding to the plurality of rigid solar cells 2. The protective housings 4 are disposed on the flexible base plate 1. The rigid solar cells 2 are disposed in the protective housings 4. The protective housings 4 protect the rigid solar cells 2. A specific structure of the protective housings 4 is not limited. For example, as shown in FIG. 1, the protective housing 4 is a box-like structure with an opening. An interior shape of the box-like structure matches a shape of the rigid solar cell 2. The rigid solar cell 2 can be installed into the protective housing 4 from the opening.

In a preferred embodiment, the protective housings 4 are made from a rigid material, such as a rigid thermal silicone sheet, a low-temperature resistant epoxy resin sheet, or a titanium alloy material. The protective housings 4 made of the rigid material can well protect fragile peripheries of the rigid solar cells 2.

A manner of connecting the protective housings 4 to the flexible base plate 1 is not limited. For example, a plurality of mounting slots (not marked) corresponding to the plurality of protective housings 4 are disposed on the flexible base plate 1. The protective housings 4 are disposed in the mounting slots. Certainly, the protective housings 4 may alternatively be connected to the flexible base plate 1 through bonding, or fastened to a surface of the flexible base plate by a fastener such as a screw.

Preferably, the protective housings, the flexible base plate, and the rigid solar cells form a plane on a lighting receiving surface of the rigid solar cells. The foregoing settings ensure appearance smoothness, and reduce damage to the protective housings 4 and the solar cells 2.

In a further embodiment, the solar cell assembly further includes a transparent protective film 5, where the protective film 5 covers the plurality of solar cells 2. Preferably, a length and a width of the protective film 5 are respectively the same as a length and a width of the flexible base plate 1. A material of the protective film 5 is not limited, provided that the protective film can transmit light and protect the solar cells 2. Preferably, the protective film 5 is made from a transparent weather-resistant material. In a preferred embodiment, the protective film 5 is made from a highly transparent, highly flexible, and weather-resistant polyvinyl chloride material, highly transparent epoxy resin, or a highly transparent silicone film.

In a further embodiment, to further improve flexibility of the flexible base plate 1, as shown in FIG. 3, a plurality of grooves 6 are disposed on a surface, back to the solar cells 2, of the flexible base plate 1, so that the flexible base plate 1 can better bend and can be well attached to a non-plane structure. In addition, the setting of the grooves 6 can mitigate stress concentration, effectively prevent problems such as cracking on the flexible base plate 1, and improve a service life of the flexible base plate 1.

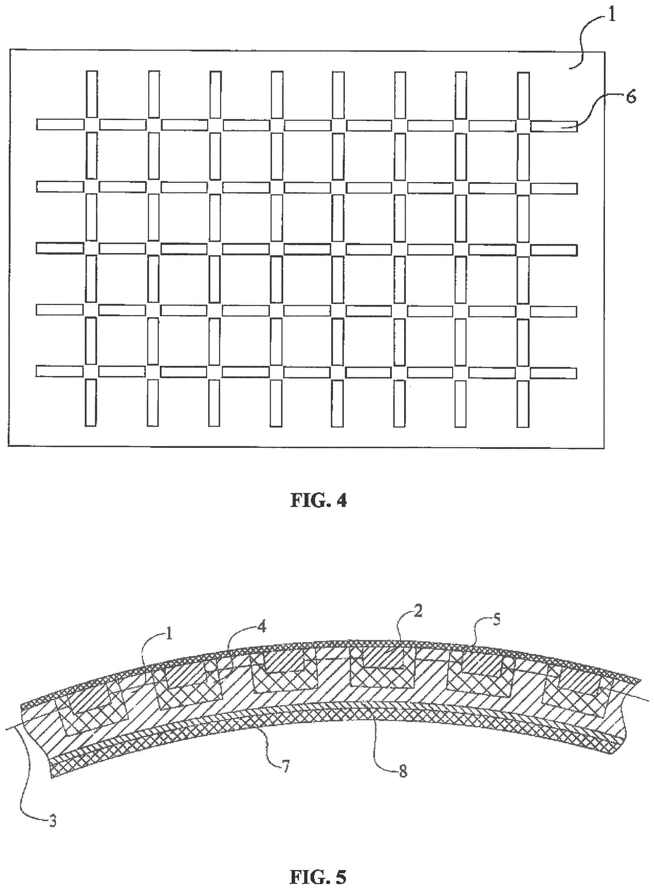

A setting manner of the grooves 6 is not limited. For example, as shown in FIG. 4, the grooves 6 are disposed in corresponding locations between adjacent solar cells 2. Further, preferably, a length of a groove 6 is the same as a length of a side edge, close to the groove, of a solar cell 2. According to the setting manner of the grooves 6 in this embodiment, when the solar cell assembly is disposed on an object whose surface is a curved surface, an extension direction of the grooves 6 may be used as a deformation location of the flexible base plate 1, so that the flexible base plate 1 can be more closely attached to a contact surface. In addition, internal stress concentration on the flexible base plate 1 is greatly mitigated.

In this embodiment, the rigid solar cells in the solar cell assembly are made to be flexible, so that the rigid solar cells with high optical-to-electrical conversion efficiency can be attached, like flexible solar cells, to a curved surface. When the solar cell assembly in this embodiment is applied to an aerostat, optical-to-electrical conversion efficiency of solar cells can be greatly improved.

Further, the present invention further provides an aerostat, including a capsule and the foregoing solar cell assembly. As shown in FIG. 5, a flexible base plate 1 of the solar cell assembly is attached to an outer surface of a capsule shell 7 of the capsule, to achieve a simple structure and high optical-to-electrical conversion efficiency. In this embodiment, the flexible base plate 1 is bonded to the surface of the capsule shell 7 by using a flexible bonding agent 8.

A specific connection structure of the solar cell assembly and the capsule shell 7 is not limited. In a preferred embodiment, the flexible base plate 1 of the solar cell assembly is bonded to the outer surface of the capsule shell 7 of the capsule by using the flexible bonding agent.

In addition, a person of ordinary skill in the art should understand that the drawings provided herein are used for description, and the drawings are not necessarily drawn in proportion.

In addition, it should be understood that the example embodiments are provided to supplement this disclosure and fully convey the scope of this disclosure to a person skilled in the art. Many particular details (such as examples of particular components, devices, and methods) are provided for full understanding of this disclosure. A person skilled in the art should understand that the example embodiments may be implemented in many different forms without using the particular details, and the example embodiments should not be understood as a limitation on the scope of this disclosure. In some example embodiments, well-known device structures and well-known technologies are not described in detail.

When a component or a layer is referred to be "on", "combined with", "connected to", or "bonded to" another component or another layer, the component or the layer may be directly on, combined with, connected to, or bonded to the another component or the another layer, or there may be an intermediate component or layer. In comparison, when a component is referred to be "directly on", "directly combined with", "directly connected to", or "directly bonded to" another component or another layer, there may be no intermediate component or layer. Other terms (for example, "between" and "directly between", or "adjacent to" and "directly adjacent to") used to describe relationships between components should be explained in a similar manner. For example, the term "and/or" used herein indicates any one of one or more associated items that are listed or a combination thereof.

Although terms such as first, second, and third herein may be used to describe components, parts, areas, layers, and/or sections, these components, parts, areas, layers, and/or sections should not be limited to the terms. The terms may be only used to distinguish a component, a part, an area, a layer, or a section from another component, area, layer, or section. Terms such as "first" and "second" and other numerical values used herein do not mean an order or a sequence, unless otherwise specified in the context. Therefore, a first component, part, area, layer, or section discussed below may be referred to as a second component, part, area, layer, or section, without departing from an instruction of the example embodiments. In addition, in the descriptions of the present invention, "a plurality of' means two or more than two, unless otherwise specified.

The foregoing descriptions are merely preferred embodiments of the present invention, but are not intended to limit the present invention. For a person skilled in the art, the present invention may have various changes and variations. Any modification, equivalent replacement, or improvement made within the spirit and principle of the present invention shall fall within the protection scope of the present invention.

## Claims

1. A solar cell assembly, comprising:
a flexible base plate; and
a plurality of rigid solar cells that are connected in series by conducting wire and that are disposed on a surface of the flexible base plate.

2. The solar cell assembly according to claim 1, wherein the plurality of rigid solar cells are arranged on the flexible base plate in a form of an array.

3. The solar cell assembly according to claim 1 or 2, further comprising a plurality of protective housings, wherein the protective housings are disposed on the flexible base plate, and the plurality of rigid solar cells are respectively disposed in the plurality of protective housings.

4. The solar cell assembly according to claim 3, wherein a plurality of mounting slots are disposed on the flexible base plate, and the plurality of protective housings are respectively disposed in the mounting slots; or
the protective housings are bonded to a surface of the flexible base plate; or
the plurality of protective housings are fastened to a surface of the flexible base plate by using fasteners.

5. The solar cell assembly according to claim 3, wherein the protective housings are made from a rigid material.

6. The solar cell assembly according to claim 5, wherein the material of the plurality of protective housings is a rigid thermal conductive silicone, a low-temperature resistant epoxy resin, or a titanium alloy.

7. The solar cell assembly according to claim 3, wherein the protective housings, the flexible base plate, and the rigid solar cells form a plane on a lighting receiving surface of the rigid solar cells.

8. The solar cell assembly according to any one of claims 1 to 7, further comprising a protective film, wherein the protective film covers the plurality of rigid solar cells.

9. The solar cell assembly according to any one of claims 1 to 7, wherein a plurality of grooves are disposed on a surface, back to the rigid solar cells, of the flexible base plate.

10. The solar cell assembly according to claim 9, wherein the plurality of grooves are respectively disposed in corresponding locations between adjacent solar cells.

11. An aerostat, comprising a body and the solar cell assembly according to any one of claims 1 to 10, wherein a flexible base plate of the solar cell assembly is attached to an outer surface of a capsule shell of the body.

12. The aerostat according to claim 11, wherein the flexible base plate of the solar cell assembly is bonded to the outer surface of the capsule shell of the body by using a flexible bonding agent.
